Europäisches Patentamt

European Patent Office

Office européen des brevets

(11) Publication number: 0 504 928 A2

# EUROPEAN PATENT APPLICATION

(21) Application number: 92104899.7

(22) Date of filing: 20.03.92

(51) Int. Cl.5: H01L 31/09, H01L 31/0224, H01L 31/20

(30) Priority: 20.03.91 JP 80619/91
05.04.91 JP 99668/91

(43) Date of publication of application:
23.09.92 Bulletin 92/39

(84) Designated Contracting States:
BE DE FR GB IT NL SE

(71) Applicant: TERUMO KABUSHIKI KAISHA
No. 44-1, Hatagaya 2-chome, Shibuya-ku
Tokyo 151(JP)

(72) Inventor: Komatsu, Kiyoshi, c/o Terumo K.K.
1500, Inokuchi, Nakai-machi
Ashigarakami-gun, Kanagawa-ken(JP)
Inventor: Kimura, Mitsuteru
2-56, Shiomidai 3-chome, Shichigahama-cho
Miyagi-gun, Miyagi-ken(JP)

(74) Representative: Henkel, Feiler, Hänzel &
Partner
Möhlstrasse 37
W-8000 München 80(DE)

(54) Thermal type infrared sensor and method for production thereof.

(57) A thermal type infrared sensor includes a bridge portion formed on a semiconductor substrate so as to bridge a cave portion formed in the substrate, a thermal sensitive film formed on the bridge portion and a pair of electrodes formed in the thermal sensitive film. The thermal sensitive film has in the whole thereof a first ion implantation region in which impurities of a first species are injected, and the electrodes are formed as concentrated impurity regions in which impurities of a second species being same as the first species are further injected so that the electrodes have the same conductivity as that of the first ion implantation region. Alternatively, impurities are doped into the thermal sensitive film so that the film has a similar property to that of an intrinsic semiconductor, and the electrodes are made of a siliside, such as silicon siliside.

Fig.1

Fig.2

## BACKGROUND OF THE INVENTION

Field of The Invention

The present invention relates generally to a thermal type infrared sensor for measuring the temperature of a subject, and a method for the production thereof. More specifically, the invention relates to a thermal type infrared sensor which can measure the temperature of a subject without contacting therewith, and which can be especially used for a thympanic clinical thermomenter.

Description of The Prior Art

In recent years, various technologies for manufacturing thermal type infrared sensors suitable for non-contact type clinical thermometers or the like by semiconductor fine patterning or micro-machining technology, have been developed. The thermal type infrared sensor generally comprises a substrate, a bridge or portion formed thereon, and a thermal sensitive portion further formed thereon. Such a thermal type infrared sensor is designed to determine the quantity of infrared (the quantity of heat) by receiving infrared on the thermal sensitive portion and converting the increase of temperature caused by the infrared to the variation of electrical resistance.

As the heat capacity of the thermal sensitive portion of such a thermal type infrared sensor is small and as the quantity of heat transferred therefrom to the outside is also small, the temperature of the thermal sensitive portion is highly increased even if the quantity of infrared is very small, so that the sensor has high sensitivity. For that reason, the thermal sensitive portion has been generally formed of a fine bridge structure or a thin diaphragm to decrease its heat capacity to enhance its sensitivity. The thermal sensitive portion of this type generally comprises a thermal sensitive film formed on a bridge portion, electrodes formed thereon, and electric wirings between the electrodes and bonding pads. Since the heat capacity and heat transfer are not influenced only by the thermal sensitive portion, but also by the electrodes and electric wirings, they must be made as finer and thinner as possible.

The electrical contacts between the electrodes and electric wirings on the thermal sensitive portion have been formed by piling electrodes up on a part of the thermal sensitive portion and by piling the electric wirings up on a part of the electrodes. When the electrodes and the electric wirings are piled up on the thermal sensitive portion, there is a disadvantages in that the breakage of electrodes or the breaking of wirings tends to be caused by differences in level therebetween to decrease the yields of products.

At the interfaces between the electrodes and the thermal sensitive portion and between the electrodes and the wirings, it is required to form electrically ideal contact (ohmic contact) states in which there is no defects of physical shapes, such as the breaking of wirings caused by the differences in level. Since the electrodes and the electric wirings are made of metals in the conventional sensors, it is difficult to form ohmic contacts if the thermal sensitive film is made of a high-resistance semiconductor which has a higher sensitivity than those of the metals. The metals which can be used as the electrodes to form the electrically ideal contacts, is generally designed to form an alloy with the thermal sensitive film to be deeply introduced into the film. Therefore, there is a disadvantage in that the dimensions between the electrodes tend to differ from their designs to cause the dispersion of resistance.

In bolometer type sensors among the infrared sensors, thermistor effect is applied to the thermal sensitive film made of a semiconductor. This thermistor effect theoretically means a phenomenon in which heat supplied to a semiconductor increases the number of free carriers excited by heat and decreases the electrical resistance of the semiconductor. The thermal sensitive film of the bolometer type sensor is preferably formed of a monocrystal type semiconductor thin film, such as silicon, which can be easily fine patterned and which has a high thermistor effect. The monocrystal thin film of silicon is generally formed by epitaxial growth. It is difficult to form the monocrystal silicon film on the fine bridge structure, and it is costly expensive if possible. For that reason, the thermal sensitive film has been formed of amolphous silicon (a-Si) or amolphous germanium (a-Ge) in the form of a thin film of about 1 $\mu$ m thickness by sputtering or chemical vapor deposition (CVD) method.

A given impurity, such as arsenic (As) or phosphorus (P), is generally doped in the thermal sensitive film of a silicon semiconductor so that it has conductivity. In this case, there is a disadvantage in that the sensitivity of the thermal sensitive film serving as a thermistor decreases, since impurities are doped in the thermal sensitive film at low levels so that the thermistor constant (B constant) decreases. To increase the thermistor constant, the thermal sensitive film is preferably made of an intrinsic semiconductor. For this end, the Fermi level Ef of the semiconductor is preferably arranged near the center of its forbidden band. Furthermore, in a case where the semiconductor includes many acceptors, donors may be supplied thereto for compensation, or impurities having deep levels, for example, gold (Au) and copper (Cu) in the case of silicon semiconductor, may be supplied thereto to cause the Fermi level Ef to be fixed at a deep impurity level. The quantity of impurity must be controlled for compensation with extremely precise. The doping of impurity has been carried out at a high temperature of not less than 1000°C by the thermal diffusion method.

However, since the thermal sensitive film has been formed on the bridge structure in the conventional thermal type infrared sensors, it is difficult to control the quantity of impurity when the doping is carried out at a high temperature by the thermal diffusion method. As a result, it is difficult to control the thermistor constant of the thermal sensitive film and the resistance thereof. Furthermore, there is a disadvantage in that the thermal sensitive film tends to deform to break the electrical contacts between the film and electrodes, so as to decrease the sensitivity of the thermal sensitive film and the yield of the product.

## SUMMARY OF THE INVENTION

It is therefore a principal object of the present invention to provide an improved thermal type infrared sensor.

It is another object of the present invention to provide the aforementioned thermal type infrared sensor which can be produced with high yield,

It is another object of the present invention to prevent the breakage between a thermal sensitive film and electrodes or the breaking of electric wirings in the aforementioned thermal type infrared sensor and to prevent imperfect contact from occurring on the interfaces therebetween.

It is further object of the present invention to increase the thermistor constant and electrical resistant of the aforementioned thermal type infrared sensor, and to enhance the controllability in the manufacturing thereof and the responsibility thereof.

According to one aspect of the present invention, a thermal type infrared sensor comprises: a supporting portion made of a semiconductor material and having a cave portion; a bridge portion formed on the supporting portion so as to bridge the cave portion; a thermal sensitive film formed on the bridge portion and having in the substantially whole thereof a first ion implantation region in which impurities of a first species are injected; and a pair of electrodes formed in the thermal sensitive film as concentrated impurity regions in which impurities of a second species being same as said first species are further injected so that the electrodes have the same conductivity as that of the first ion implantation region.

The semiconductor material may be selected from the group consisting of silicon and germanium, and it is preferably silicon. The bridge portion may be formed of a silicon oxynitride film. The thermal sensitive film may be made of a material selected from the group consisting of an amolphous silicon and an amolphous germanium, and it is preferably made of an amolphous silicon. The first and second impurities may be selected from the group consisting of arsenic and phosphorus.

According to another aspect of the present invention, a method for manufacturing a thermal type infrared sensor comprises the steps of: preparing a supporting portion of a semiconductor material; forming a bridge portion on the supporting portion and forming a cave portion in the supporting portion so that the bridge portion bridges the cave portion; forming a thermal sensitive film on the bridge portion; injecting impurities of a first species into the thermal sensitive film; and patterning the thermal sensitive film and injecting impurities of a second species being same as the first species so as to form a pair of concentrated impurity regions serving as electrodes in the thermal sensitive film.

The bridge portion forming step may comprise the steps of depositing a silicon oxynitride film on a silicon substrate serving as the supporting portion, and patterning the deposited silicon oxynitride film.

According to another aspect of the present invention, a thermal type infrared sensor comprises: a supporting portion made of a semiconductor material and having a cave portion; a bridge portion formed on the supporting portion so as to bridge the cave portion; a thermal sensitive film which is formed on the bridge portion and in which impurities are doped so that the thermal sensitive film has a similar property to that of an intrinsic semiconductor; and a pair of electrodes of a siliside formed on the thermal sensitive film.

The electrodes may be made of the siliside of an element selected from titanium, platinum and molybdenum, and the siliside is preferably titanium siliside. The thermal sensitive film may be made of a material selected from the group consisting of a crystallized amolphous silicon and a crystallized amolphous germanium, and it is preferably made of an amolphous silicon polycrystallised by heat treatment. The impurities may be selected from phosphorus, gold and copper, and they are preferably phosphorus.

According to another aspect of the present invention, a method for manufacturing a thermal type infrared sensor comprises the steps of: preparing a supporting portion of a semiconductor material; forming a bridge portion on the supporting portion and forming a cave portion in the supporting portion so that the bridge portion bridges the cave portion; forming a thermal sensitive film on the bridge portion; injecting impurities into the thermal sensitive film so as to cause the film to have a similar property to an intrinsic semiconductor; heating the thermal sensitive film in which the impurities are injected; and forming a pair of electrodes of a siliside on the thermal sensitive film.

The thermal sensitive film forming step may comprise the steps of: depositing amolphous silicon on the bridge portion by sputtering; and polycrystallizing the deposited amolphous silicon. The electrodes forming step comprises the steps of: depositing a titanium film on the thermal sensitive film; patterning the titanium film so as to define a pair of electrode separated from each other at a predetermined distance; converting the patterned titanium film to a titanium siliside film defining the electrodes by sintering; and removing the unreacted titanium and the oxide thereof by etchant.

## BRIEF DESCRIPTION OF THE DRAWINGS

The present invention will be understood more fully from the detailed description given herebelow and from the accompanying drawings of the preferred embodiments of the invention. However, the drawings are not intended to imply limitation of the invention to a specific embodiment, but are for explanation and understanding only.

In the drawings:

Fig. 1 is a schematic plan view of the first preferred embodiment of a thermal type infrared sensor, according to the present invention;

Fig. 2 is a schematic perspective view of the main portion of the thermal type infrared sensor of Fig. 1;

Figs. 3(a) to (g) are sectional views taken along the line III-III of Fig. 1 for explaining a process for manufacturing the thermal type infrared sensor of Fig. 1;

Fig. 4 is a schematic plan view of the second preferred embodiment of a thermal type infrared sensor, according to the present invention;

Fig. 5 is a schematic perspective view of the main portion of the thermal type infrared sensor of Fig. 4; and

Figs. 6(a) to 6(g) are sectional views taken along the line VI-VI of Fig. 4 for explaining a process for manufacturing the thermal type infrared sensor of Fig. 4.

## DESCRIPTION OF THE PREFERRED EMBODIMENT

According to the first preferred embodiment of the present invention, a thermal type infrared sensor comprises: a supporting portion made of a semiconductor material and having a cave or recessed portion; a bridge portion formed on the supporting portion to bridge the cave portion; a thermal sensitive film formed on the bridge portion and having in whole a first ion implantation region formed by injecting first impurities into the thermal sensitive film; and a pair of electrodes formed on the thermal sensitive film as concentrated impurity regions by injecting second impurities so that the electrodes has the same conductivity as that of the first ion implantation region.

In this embodiment, the concentrated impurity regions are formed in the thermal sensitive film to be used as the electrodes, so that differences in level between the electrodes and the thermal sensitive film can be decreased as compared with those of conventional structures. Therefore, electric wirings can be directly connected to the electrodes in the thermal sensitive film to prevent the breaking of wiring from occurring due to the differences in level. Furthermore, since the wirings can be connected to the electrodes at positions offset from the high-resistance thermal sensitive film, the distance between the electrodes (the dimension of the high-resistance region) can be set with high accuracy. In addition, it is possible to prevent imperfect contacts from occurring on the interfaces between the thermal sensitive film and the electrodes so as to easily form ohmic contacts therebetween. As a result, it is possible to enhance the sensitivity of the thermal sensitive film and the yield of the product. In a case where aluminum electrodes are formed on the thermal sensitive film of the conventional sensor, there is a disadvantage in that the infrared incident thereon is reflected to decrease the sensitivity of the thermal sensitive film. According to this embodiment of the present invention, since the electrodes are not required to be made of a metal, it is possible to eliminate the aforementioned problem, and to decrease the heat capacity of the sensitive portion to enhance the sensitivity thereof.

The impurities previously injected into the thermal sensitive film in whole serve to cause the property of the film itself to approach that of an intrinsic semiconductor and to cause the film to have the conductivity to adjust the resistance thereof. In a case where this film is formed as a p-type semiconductor, the impurity region of the electrode may be formed by injecting the same p-type impurity to form a concentrated $p^+$-type region On the other hand, in a case where the film is formed as a n-type semiconductor, the impurity region of the electrode may be formed by injecting the same n-type impurity to form a concentrated $n^+$-type region. In either case where the impurity region of the electrode is $p^+$-type or $n^+$-type, ohmic contact may be formed between the $p^+$-type or $n^+$-type region and the electric wiring connected to the electrode in the thermal sensitive film so as to enhance the contact state, if the material of the electric wiring is selected from aluminum (Al), titanium (Ti) or the like to be sintered.

A method for manufacturing the first preferred embodiment of a thermal type infrared sensor, according to the present invention, includes a first ion implantation step for injecting impurities into the whole of a thermal sensitive film formed on a bridge portion, and a second ion implantation step for forming a concentrated impurity region serving as an electrode by further injecting into the thermal sensitive film the same impurity as that in the first ion implantation step.

The aforementioned method of the present invention is particularly effective when a thermal sensitive film must be formed as finer and thinner as possible. The impedance of the thermal sensitive film is designed on the basis of the width of the electrode and the distance between the opposite electrodes. In the heat diffusion method, the manufacturing errors tend to occur in the patterning, such as photolithography and etching, of the electrodes, and in the diffusion and alloying by the heat treatment, such as sintering. In the ion implantation method, the lateral diffusion and the diffusion depth are relatively small as compared with the heat diffusion method, and the diffusion can be carried out at a low temperature (room temperature), so that the aforementioned manufacturing errors can be decreased. Furthermore, the dose (added quantity) and the injected depth of the impurity can be accurately set. Therefore, the thermistor constant and the electrical resistance of the thermal sensitive film can be accurately controlled, and the responsibility of the thermal sensitive film and the repeatability of electric characteristics thereof can be enhanced.

The conditions of the ion implantation into the thermal sensitive film are as follows.

The first ion implantation step is carried out to allow the thermal sensitive film to be sensitive relative to temperature. The kind of ion and the dose thereof are determined so that the thermal sensitive film has a similar property to an intrinsic semiconductor after heat treatment. If the thermal sensitive film becomes p-type after the heat treatment without the ion implantation, it is preferable to inject n-type impurities therein for compensation. For example, when the thermal sensitive film is made of a silicon (Si) thin film of $1 \mu m$ thickness and when the concentration of p-type acceptor is $1 \times 10^{16} /cm^3$, a compensated intrinsic semiconductor is formed if phosphorus (P) of a dose of $1 \times 10^{13}/cm^3$ is injected, and a n-type semiconductor is formed if phosphorus of a more quantity than the aforementioned value is injected. In practice, in the case of silicon, the resistance of the perfectly intrinsic semiconductor is so high that it can be used. Therefore, it is preferable to adjust the resistance so that the property of the thermal sensitive film is slightly offset from that of the intrinsic semiconductor toward n-type semiconductor. The second ion implantation step is carried out to form a concentrated impurity regions serving as electrodes so as to form ohmic contact between the concentrated impurity region and the thermistor portion (thermal sensitive portion) directly below a mask for the ion implantation in the high-resistance thermal sensitive film formed by the first ion implantation. To obtain the ohmic constant between the concentrated impurity region and the thermistor portion, they must have the same conductivity. If the thermistor portion is n-type after the first ion implantation step, n-type impurity may be injected in the second ion implantation step. To decrease the resistance, a great amount of impurities may be injected. For example, when the thermal sensitive film is made of a silicon of $1 \mu m$ thickness, phosphorus (P) or arsenic (As) of a dose of $1 \times 10^{17} /cm^3$ may be injected as n-type impurity at 280keV. This corresponds to a concentration of $1 \times 10^{20}/cm^3$ of the concentrated impurity when the doping efficiency is 100% and when the impurity is distributed evenly in the direction of depth by the heat treatment. In this case, it is sufficient that the heat treatment is carried out at 1100 °C for 1 hour.

The thermal sensitive film may be formed of amolphous silicon (a-Si) or amolphous germanium (a-Ge) by the sputtering or CVD method, and it is preferably formed as a thin film having a thickness of 0.5 to $3 \mu m$.

The substrate may be made of a semiconductor, such as silicon and germanium. It is preferably a monocrystal silicon substrate easily and cheaply available. The bridge portion is preferably made of a silicon oxynitride (SiOxNy) film. This silicon oxynitride film has both properties of silicon oxide and silicon nitride films. Therefore, the silicon oxynitride film has a good stress balance to form a stable bridge structure. The thickness of the silicon oxynitride film is preferably 0.1 to $50 \mu m$. If the thickness is less than $0.1 \mu m$, the film is so thin that it can not have sufficient strength. On the other hand, if the thickness is more than $50 \mu m$, the heat capacity of the film is so high that the sensitivity is decreased. The silicon oxynitride film may be formed by the plasma CVD method. In this method, monosilane ($SiH_4$), nitrogen ($N_2$) or nitrous oxide gas ($N_2O$) may be used. By varying the flow rate ($N_2/(N_2 + N_2O)$) of $N_2$ and $O_2$ gases, the stoichiometric composition x, y of the silicon oxynitride film may be controlled, and the thermal expansion coefficient of the film may be substantially same as that of the silicon substrate so as to prevent the sensor from being broken due to stress.

According to the second preferred embodiment of the present invention, a method for manufacturing a thermal type infrared sensor includes the steps of: forming a thermal sensitive film on a bridge portion formed on a semiconductor substrate; injecting impurities into the thermal sensitive film so that the film has a property of an intrinsic semiconductor or a similar property to that of the intrinsic semiconductor; heating the semiconductor substrate containing therein the impurities at a given temperature; and forming electrodes on the thermal sensitive film.

In this method, the dose of impurity and the injected depth thereof can be accurately set as compared with the thermal diffusion method. Therefore, it is easily possible to cause the thermal sensitive film to have a similar property to that of the intrinsic semiconductor. The impurities may be evenly diffused in the thin thermal sensitive film by the heat treatment for a short time, so that an intrinsic semiconductor or a semiconductor having a similar property to that of the intrinsic semiconductor, in which the impurities are evenly diffused, can be easily obtained. Furthermore, the thermistor constant and the electrical resistance of the film can be increased and easily controlled so as to enhance its responsibility and its repeatability of electrical characteristics.

The thermal sensitive film is preferably formed by depositing amolphous silicon (a-Si) or amolphous germanium (a-Ge) by the sputtering method, and then, by polycrystallizing or monocrystallizing it by the heat treat treatment. Alternatively, the polycrystallization may be carried out by the CVD method. The thickness of the thermal sensitive film is preferably about 1 $\mu$ m.

The ion implantation into the thermal sensitive film is carried out so that the thermal sensitive thin film of a semiconductor has the property of an intrinsic semiconductor or a similar property to that of the intrinsic semiconductor after the heat treatment. If the thermal sensitive film is p-type without the ion implantation, n-type impurities may be injected, and if the thermal sensitive film is n-type, p-type impurities may be injected to form a compensated semiconductor. When the thermal sensitive film is so formed as to have a similar property to that of the intrinsic semiconductor, if the film is made of a silicon semiconductor, Fermi level of the semiconductor may be fixed at the center of the forbidden band by injecting impurities which can form a deep impurity level, such as gold (Au) and copper (Cu).

For example, if the acceptor concentration of the thermal sensitive film of a silicon of 1 $\mu$ m thickness is $1 \times 10^{16}$ /cm$^3$ after the heat treatment without the ion implantation, phosphorus (P) serving as n-type impurity may be injected with a dose of $1 \times 10^{13}$/cm$^3$. These values are determined on the basis of 100% of doping efficiency since it is theoretically 100% after the heat treatment at a temperature of more than 850°C. In practice, the aforementioned values must be experimentally adjusted. When the acceptor concentration is $1 \times 10^{16}$ /cm$^3$ as mentioned above, the dose may be, for example, $5 \times 10^{13}$ /cm$^3$ so that the concentration of gold or copper is more than $1 \times 10^{16}$/cm$^3$.

In the heat treatment process, the following three requirements must be satisfied. The first requirement is that the injected impurities must be evenly diffused in a thin thermal sensitive film of 1 $\mu$ m thickness. For this end, it is sufficient for the heat treatment to be carried out at 900°C for 30 minutes. The second requirement is that all the injected impurities must be activated, i.e. the doping efficiency must be 100%. For this end, the heat treatment may be carried out at a temperature of more than 850°C . The third requirement is that the amolphous layer on the thermal sensitive film damaged by the ion implantation must be crystallized, or that the thermal sensitive film formed as an amolphous state by the sputtering must be crystallized. For this end, the heat treatment may be carried out at 1050°C for about 1 hour. To satisfy these three requirements, the heat treatment may be carried out at 1100°C for 1 hour.

In the formation of electrode on the thermal sensitive film, an ohmic electrode may be formed by the formation of a low-resistance siliside of titanium (Ti), platinum (Pt), molybdenum (Mo) or the like. For example, the electrodes may be formed by depositing titanium of a thickness of about 500Å on the thermal sensitive film, by patterning desired shapes of electrodes by the photolithography, by sintering it at 650°C , and then, by etching the unreacted titanium and the oxide thereof.

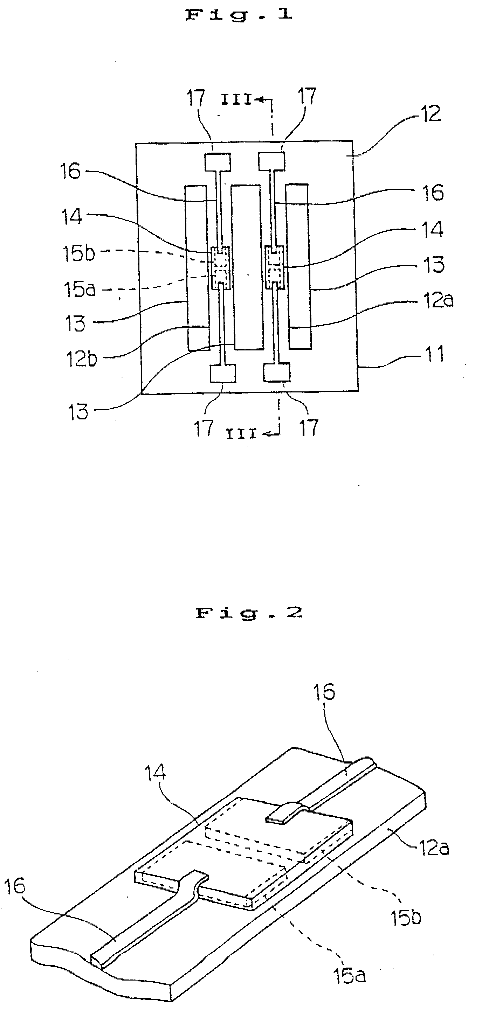

Referring now to the drawings, particularly Figs. 1, 2 and 3(a) to 3(g), the first preferred embodiment of a thermal type infrared sensor of the present invention will be described below.

Fig. 1 shows the first preferred embodiment of a thermal type infrared sensor, according to the present invention, and Fig. 2 shows the main portion of the sensor of Fig. 1. In this sensor, a cave portion 13 is formed in a silicon substrate 11 serving as a supporting portion at the center thereof. On the silicon substrate 11, a silicon oxynitride film 12 is formed. The silicon oxynitride film 12 has a pair of bridge portions 12a and 12b which bridge the cave portion 13. The respective bridge portions 12a and 12b have a width of 100 $\mu$ m, a length of 2mm and a thickness of 2 $\mu$ m. On the respective bridge portions 12a and 12b at their centers, thermal sensitive films 14 of an amolphous silicon (a-Si) are formed. In the thermal sensitive films 14, arsenic (As) is doped as impurity so that the films 14 have conductivity. In the respective thermal sensitive films 14, a pair of electrodes 15a and 15b are so formed as to be separated from each other by a predetermined distance. These electrodes 15a and 15b are formed of a concentrated impurity region of arsenic. The respective electrodes 15a and 15b are connected to one ends of electric wirings 16, the other ends of which are connected to bonding pads 17 formed on the silicon oxynitride film 12 near the ends of the bridge portions 12a and 12b. The electric wirings 16 are made of aluminum (Al).

In this thermal type infrared sensor, the electrical resistance of the thermal sensitive film 14 is designed to vary in accordance with the quantity of incident infrared (the quantity of heat). The quantity of infrared can be detected by measuring the electrical current passing through the electrodes 15a and 15b and the electric wirings 16 in accordance with the variation of the resistance, or the voltage value between the bonding pads 17, by means of a signal processing circuit (not shown).

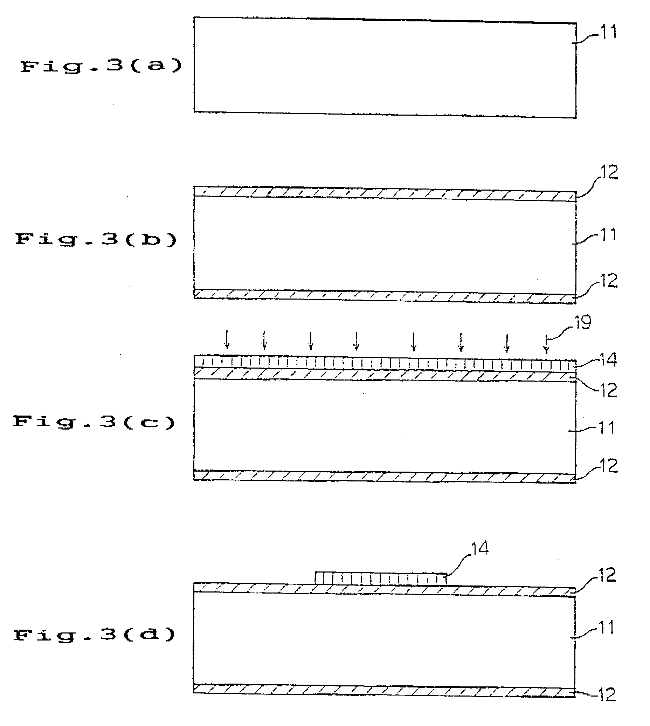

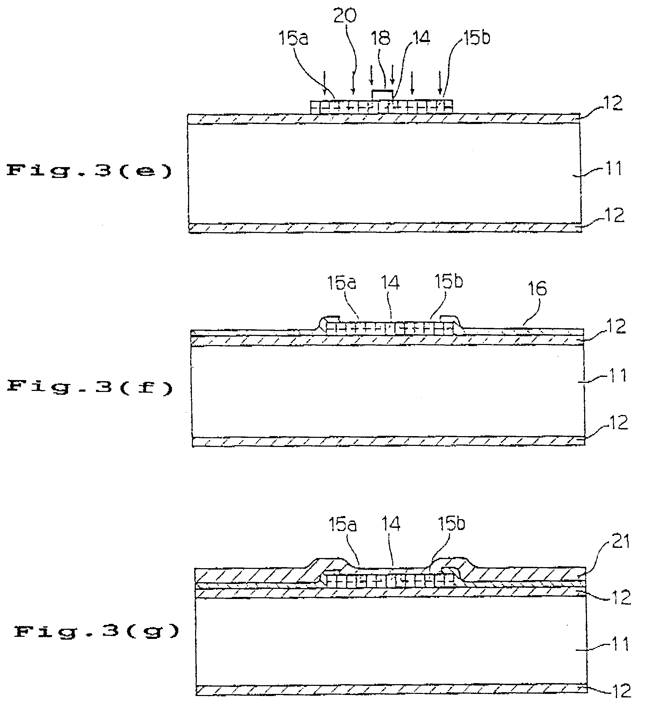

Referring to Figs. 3(a) to 3(g), a process for manufacturing the aforementioned thermal type infrared sensor, according to the present invention, will be described below.

First, a silicon substrate 11 with a surface orientation of (110) was prepared as shown in Fig. 3-(a). Then, silicon oxynitride films 12 having a thickness of $2 \mu$ m were deposited on the silicon substrate 11 by plasma CVD method as shown in Fig. 3(b). That is, the silicon substrate 11 was heated to $450°C$ to cause the vapor phase growth of the silicon oxynitride on the silicon substrate 11 under a film forming condition maintaining a pressure of 0.45Torr and a high-frequency output of 400W, using as reaction gases 15SCCM of monosilane ($SiH_4$), 203SCCM of nitrogen ($N_2$) and 32SCCM of nitrous oxide gas ($N_2O$).

Subsequently, the sputtering was carried out using silicon as a target to deposit a thermal sensitive film 14 made of amolphous silicon (a-Si) on the silicon oxynitride film 12 as shown in Fig. 3(c). This sputtering was carried out for 10 minutes under a condition in which the gas flow rates of argon (Ar) and hydrogen ($H_2$) were respectively 2SCCM and 1SCCM, the film forming pressure being $3 \times 10^{-3}$ Torr and the high-frequency output being 200W.

Thereafter, as a first ion implantation process, phosphorous (P) 19 of a dose of $1 \times 10^{13}$ /$cm^3$ was implanted into the thermal sensitive film 14, and then, the heat treatment was carried out at $1100°C$ for 1 hour. Subsequently, the thermal sensitive film 14 was patterned by reactive ion etching (RIE) as shown in Fig. 3(d).

Then, as shown in Fig. 3(e), electrodes 15a and 15b of concentrated impurity regions were formed on the thermal sensitive film 14 by patterning with a photoresist 18 and by implanting phosphorous (P) 20 of a dose of $1 \times 10^{17}$/$cm^3$, which is the same species as that in the first ion implantation. This implantation serves as a second ion implantation.

After the photoresist 18 was removed, electric wirings 16 of aluminum thin films were formed so that one ends thereof were connected to the electrodes 15a and 15b as shown in Fig. 3(f).

Subsequently, in order to protect the thermal sensitive film 14 and the electric wirings 16 from the aqueous solution of hydrazine which will be described hereinafter, a silicon oxynitride film 21 was deposited thereon as shown in Fig. 3(g).

Then, the silicon oxynitride films 12 and 21 were patterned so as to form bridge portions 12a and 12b as shown in Fig. 1. This patterning was continued by the reactive ion etching (RIE) until the silicon substrate 11 was exposed to the outside. In this etching, methane trifluoride ($CHF_3$), fleon 14 ($CF_4$) and oxygen ($O_2$) were used as etching gases, the flow rates thereof were $CHF_3$ = 30SCCM, $CF_4$ = 8SCCM and $O_2$ = 2SCCM, the pressure for the etching was 0.08Torr, the high-frequency output was 300W and the etching time was 40 minutes. Finally, the silicon substrate below the bridge portions 12a and 12b was selectively etched to form a cave portion 13. This etching was anisotropic etching using the aqueous solution of hydrazine. Alternatively, the aqueous solution of potassium hydroxide may be used in this anisotropic etching.

In this embodiment, the concentrated impurity regions are formed in the thermal sensitive film 14 to be used as the electrodes 15a and 15b, and the electric wirings 16 are directly connected to the electrodes 15a and 15b in the thermal sensitive film 14. Therefore, differences in level between the electrodes 15a and 15b and the thermal sensitive film 14 can be decreased as compared with those of conventional structures so as to restrain the breaking of wiring from occurring due to the differences in level. Furthermore, it is possible to eliminate the problem with respect to imperfect contact on the interfaces between the thermal sensitive film 14 and the electrodes 15a and 15b, so as to easily form ohmic contacts therebetween. As a result, it is possible to enhance the sensitivity of the thermal sensitive film 14 and the yield of the product.

According to this embodiment, it is possible to diffuse impurities in the thermal sensitive film 14 at low temperatures since the ion implantation method by which the diffusion depth thereof is smaller than that by the thermal diffusion method, is used in the implantation of impurity into the thermal sensitive film 14. Therefore, it can be easily applied to the process for forming the thermal sensitive film having fine and thin bridge structures, so as to accurately set the dose and implantation depth of impurity. As a result, the thermistor constant and the electrical resistance of the thermal sensitive film can be easily controlled to enhance the sensitivity of the thermal sensitive film and the repeatability of the electrical characteristics thereof.

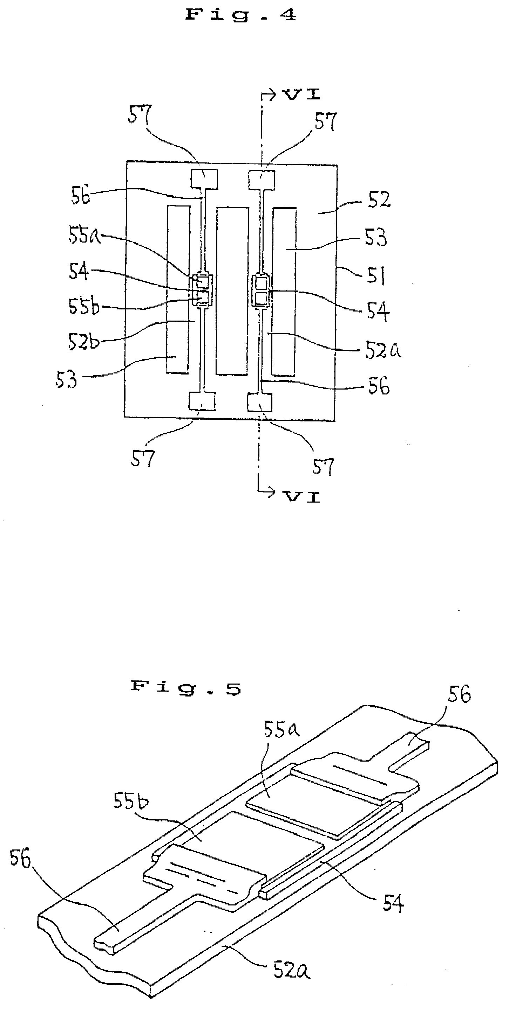

Figs. 4, 5 and 6(a) to 6(g) show the second preferred embodiment of a thermal type infrared sensor, according to the present invention.

In this sensor, a cave portion 53 is formed in a silicon substrate 51 serving as a supporting portion at the center thereof. On the substrate 51, a silicon oxynitride film 52 is formed. The silicon oxynitride film 52 has a pair of bridge portions 52a and 52b having a width of 100 $\mu$ m, a length of 2mm and a thickness of 2 $\mu$ m. Thermal sensitive films 54 are formed on the respective bridge portions 52a and 52b at their centers. The thermal sensitive films 54 are made of an amolphous silicon (a-Si) polycrystallized by heat treatment after sputtering. In the thermal sensitive films 54, arsenic (As) are doped as impurity so that the films 54 have the property of an intrinsic semiconductor. In the respective thermal sensitive films 14, a pair of electrodes 55a and 55b are so formed as to be separated from each other by a predetermined distance. These electrodes 55a and 55b are made of a titanium siliside film. The respective electrodes 55a and 55b are connected to one ends of electric wirings 56, the other ends of which are connected to bonding pads 57 formed on the silicon oxynitride film 52 near the ends of the bridge portions 52a and 52b. The electric wirings 56 are made of aluminum (Al).

Similar to the first preferred embodiment of a thermal type infrared sensor, the electrical resistance of the thermal sensitive film 54 is designed to vary in accordance with the quantity of incident infrared (the quantity of heat). The quantity of infrared can be detected by measuring the electrical current passing through the electrodes 55a and 55b and the electric wirings 56 in accordance with the variation of the resistance, or the voltage value between the bonding pads 57, by means of a signal processing circuit (not shown).

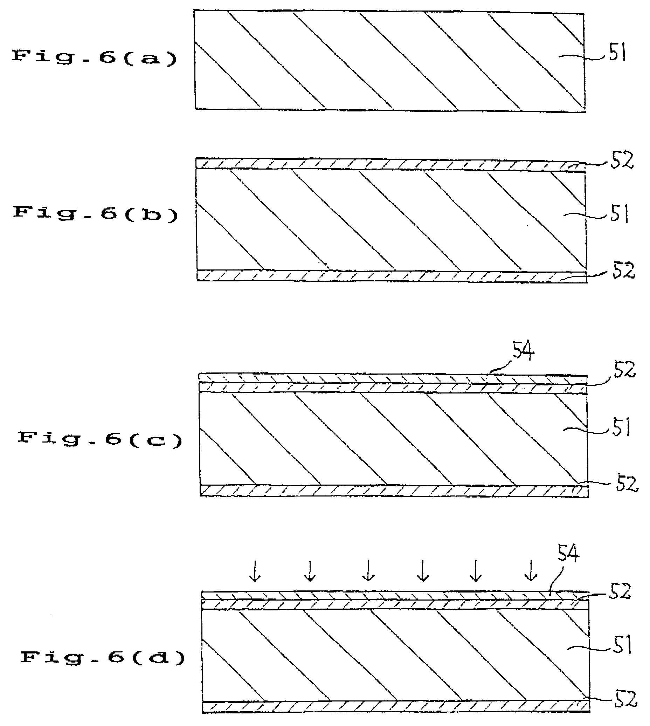

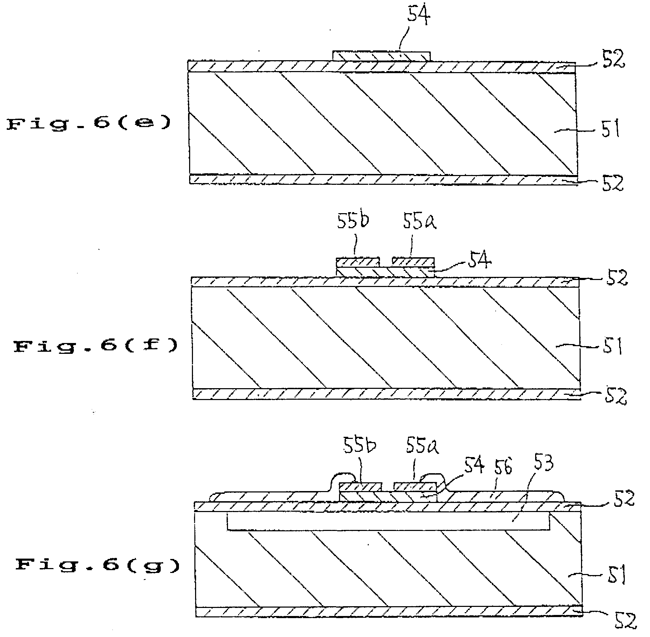

Referring to Figs. 6(a) to 6(g), a process for manufacturing the aforementioned thermal type infrared sensor, according to the present invention, will be described below.

First, a silicon substrate 51 with a surface orientation of (110) was prepared as shown in Fig. 6-(a). Then, a silicon oxynitride films 52 having a thickness of 2 $\mu$ m were deposited on the silicon substrate 51 by the Plasma CVD method as shown in Fig. 6(b). That is, the silicon substrate 51 was heated to 450°C to cause the vapor phase growth of the silicon oxynitride on the silicon substrate 51 under a film forming condition maintaining a pressure of 0.45Torr and a high-frequency output 400W, using as reaction gases 15SCCM of monosilane ($SiH_4$), 203SCCM of nitrogen ($N_2$) and 32SCCM of nitrous oxide gas ($N_2O$).

Subsequently, the sputtering was carried out using silicon as a target to deposit a thermal sensitive film 54 made of amolphous silicon (a-Si) on the silicon oxynitride film 52 as shown in Fig. 6(c). This sputtering was carried out for 10 minutes under a condition in which the gas flow rates of argon (Ar) and hydrogen ($H_2$) are respectively 2SCCM and 1SCCM, the film forming pressure being $3 \times 10^{-3}$ Torr and the high-frequency output being 200W.

Subsequently, impurities of phosphorous (P) were injected into the thermal sensitive film 54 was carried out as shown in Fig. 6(d) so that the film 54 has the property of an intrinsic semiconductor. In this ion implantation, the dose of phosphorous was $1 \times 10^{13}/cm^3$, and thereafter, heat treatment was carried out at 1100°C for 1 hour.

Then, the thermal sensitive film 54 was patterned as shown in Fig. 6(e). Subsequently, titanium film was deposited on the thermal sensitive film 54 and the silicon substrate 51 by vapor deposition method, and then, the patterning thereof was carried out to form electrodes 55a and 55b which are separated from each other by a predetermined distance as shown in Fig. 6(f). Then, a titanium siliside film was deposited thereon by sintering at 650°C for 5 minutes, and the unreacted titanium and the oxide film thereof were removed by etchant.

Then, aluminum having a thickness of about 1000Å was deposited thereon by vacuum deposition, and it was patterned by etching to form electric wirings 56 as shown in Fig. 6(g).

Subsequently, the silicon oxynitride film 52 was patterned to form bridge portions 52a and 52b as shown in Fig. 4. This patterning was carried out by reactive ion etching (RIE) until the silicon substrate 51 was exposed to the outside. In this etching, methane trifluoride ($CHF_3$), fleon 14 ($CF_4$) and oxygen ($O_2$) were used as etching gases, the flow rates thereof were $CHF_3 = 30SCCM$, $CF_4 = 8SCCM$ and $O_2 = 2SCCM$, the pressure for etching was 0.075Torr, the high-frequency output was 300W and the etching time was 40 minutes.

Finally, the silicon substrate 51 under the bridge portions 52a and 52b was selectively etched to form a cave portion 53. This etching was anisotropic etching using the aqueous solution of hydrazine. The aqueous solution of potassium hydroxide may be used in this anisotropic etching.

According to this embodiment, in the implantation of impurity into the thermal sensitive film 54, the dose and implantation depth of impurity can be accurately set as compared with those in the thermal diffusion method. Therefore, it is possible to easily form the thermal sensitive film 54 as as to have the property of an intrinsic semiconductor, and to evenly implant the impurities into the film 54. As a result, it is possible to increase the thermistor constant and the electrical resistance of the thermal sensitive film 54, and to enhance the controllability, the sensitivity and the repeatability of electrical characteristics thereof.

While the present invention has been disclosed in terms of the preferred embodiments in order to facilitate better understanding thereof, it should be appreciated that the invention can be embodied in various ways without departing from the principle of the invention. For example, in the first and second preferred embodiments, although the bridge portions 12a and 12b or 52a and 52b are formed by anisotropic etching after the ion implantation into the thermal sensitive film 14 or 54, they may be formed before the ion implantation. In the first preferred embodiment, although the second ion implantation is carried out to form electrodes after the first ion implantation, the thermal sensitive films may be formed by the ion implantation after the formations of the electrodes.

**Claims**

1. A thermal type infrared sensor comprising:
a supporting portion made of a semiconductor material and having a cave portion;
a bridge portion formed on the supporting portion so as to bridge the cave portion;
a thermal sensitive film formed on the bridge portion and having in the substantially whole thereof a first ion implantation region in which impurities of a first species are injected; and
a pair of electrodes formed in the thermal sensitive film as concentrated impurity regions in which impurities of a second species being same as said first species are further injected so that the electrodes have the same conductivity as that of the first ion implantation region.

2. A thermal type infrared sensor as set forth in claim 1, wherein said semiconductor material is selected from the group consisting of silicon and germanium.

3. A thermal type infrared sensor as set forth in claim 1, wherein said semiconductor material is silicon.

4. A thermal type infrared sensor as set forth in claim 1, wherein said bridge portion is formed of a silicon oxynitride film.

5. A thermal type infrared sensor as set forth in claim 1, wherein said thermal sensitive film is made of a material selected from the group consisting of an amolphous silicon and an amolphous germanium.

6. A thermal type infrared sensor as set forth in claim 1, wherein said thermal sensitive film is made of an amolphous silicon.

7. A thermal type infrared sensor as set forth in claim 1, wherein said first and second impurities are selected from the group consisting of arsenic and phosphorus.

8. A method for manufacturing a thermal type infrared sensor comprising the steps of:
preparing a supporting portion of a semiconductor material;
forming a bridge portion on said supporting portion and forming a cave portion in said supporting portion so that the bridge portion bridges the cave portion;
forming a thermal sensitive film on said bridge portion;
injecting impurities of a first species into said thermal sensitive film; and
patterning said thermal sensitive film and injecting impurities of a second species being same as said first species so as to form a pair of concentrated impurity regions serving as electrodes in said thermal sensitive film.

9. A method as set forth in claim 8, wherein said bridge portion forming step comprises the steps of depositing a silicon oxynitride film on a silicon substrate serving as the supporting portion, and patterning the deposited silicon oxynitride film.

10. A thermal type infrared sensor comprising:
a supporting portion made of a semiconductor material and having a cave portion;
a bridge portion formed on the supporting portion so as to bridge the cave portion;
a thermal sensitive film which is formed on the bridge portion and in which impurities are doped so that the thermal sensitive film has a similar property to that of an intrinsic semiconductor; and
a pair of electrodes of a siliside formed on the thermal sensitive film.

11. A thermal type infrared sensor as set forth in claim 10, wherein said electrodes are made of the siliside of an element selected from titanium, platinum and molybdenum.

**12.** A thermal type infrared sensor as set forth in claim 10, wherein said siliside is titanium siliside.

**13.** A thermal type infrared sensor as set forth in claim 10, wherein said semiconductor material is selected from the group consisting of silicon and germanium.

**14.** A thermal type infrared sensor as set forth in claim 10, wherein said semiconductor material is silicon.

**15.** A thermal type infrared sensor as set forth in claim 10, wherein said bridge portion is formed of a silicon oxynitride film.

**16.** A thermal type infrared sensor as set forth in claim 10, wherein said thermal sensitive film is made of a material selected from the group consisting of a crystallized amolphous silicon and a crystallized amolphous germanium.

**17.** A thermal type infrared sensor as set forth in claim 10, wherein said thermal sensitive film is made of an amolphous silicon polycrystallized by heat treatment.

**18.** A thermal type infrared sensor as set forth in claim 10, wherein said impurities are selected from phosphorus, gold and copper.

**19.** A thermal type infrared sensor as set forth in claim 10, wherein said impurities are phosphorus.

**20.** A method for manufacturing a thermal type infrared sensor comprising the steps of:

preparing a supporting portion of a semiconductor material;

forming a bridge portion on said supporting portion and forming a cave portion in said supporting portion so that the bridge portion bridges the cave portion;

forming a thermal sensitive film on said bridge portion;

injecting impurities into said thermal sensitive film so as to cause the film to have a similar property to an intrinsic semiconductor;

heating said thermal sensitive film in which said impurities are injected; and

forming a pair of electrodes of a siliside on said thermal sensitive film.

**21.** A method as set forth in claim 20, wherein said thermal sensitive film forming step comprises the steps of: depositing amolphous silicon on said bridge portion by sputtering; and polycrystallizing the deposited amolphous silicon.

**22.** A method as set forth in claim 20, wherein said electrodes forming step comprises the steps of:

depositing a titanium film on said thermal sensitive film;

patterning said titanium film so as to define a pair of electrode separated from each other at a predetermined distance;

converting said patterned titanium film to a titanium siliside film defining the electrodes by sintering; and

removing the unreacted titanium and the oxide thereof by etchant.

Fig. 1

Fig. 2

11

Fig.3(a)

~11

Fig.3(b)

12

11

12

19

14
12

Fig.3(c)

11

12

14

12

Fig.3(d)

11

12

Fig.3(e)

Fig.3(f)

Fig.3(g)

Fig.4

Fig.5

Fig.6(a)

— 51

Fig.6(b)

— 52
— 51
— 52

Fig.6(c)

54
— 52
— 51
— 52

Fig.6(d)

54
— 52
— 51
— 52

Fig.6(e)

Fig.6(f)

Fig.6(g)